(19) **Europäisches Patentamt / European Patent Office / Office européen des brevets**

(11) **EP 4 730 631 A1**

(12) **EUROPEAN PATENT APPLICATION**

(43) Date of publication:
**22.04.2026 Bulletin 2026/17**

(21) Application number: **24306743.6**

(22) Date of filing: **18.10.2024**

(51) International Patent Classification (IPC):
**H02M 1/38** (2007.01)     **H03K 17/00** (2006.01)
**H02M 7/5387** (2007.01)     **H03K 17/14** (2006.01)

(52) Cooperative Patent Classification (CPC):
**H02M 7/5387; H02M 1/38; H03K 17/145**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Schneider Toshiba Inverter Europe SAS**
**27120 Pacy-sur-Eure (FR)**

(72) Inventor: **LOIZELET, Philippe**
**27120 LE PLESSIS HÉBERT (FR)**

(74) Representative: **Plasseraud IP**
**104 Rue de Richelieu**
**CS92104**
**75080 Paris Cedex 02 (FR)**

(54) **COMPENSATION OF A DEAD TIME IN A PWM-CONTROLLED SWITCHING ARM**

(57)     Examples include system and method for compensating dead times in a Pulse Width Modulation control applied to a switching arm connected between two supply lines, for example a switching arm of an inverter.

FIG. 4

EP 4 730 631 A1

**Description**

BACKGROUND

The present disclosure relates to a method and system for compensating dead times in PWM (Pulse Width Modulation) control of a switching arm, the switching arm being, for example, used in a variable speed drive (VSD), also called voltage source inverter (VSi).

It is known that an inverter, commonly used in a variable speed drive, has several switching arms, each connected to an electric load to be controlled. The switching arms are connected in parallel between two power lines connected to a voltage source. Each arm comprises at least two switches connected in series between the two power lines and a midpoint located between the first switch and the second switch, which is connected to an electric load. Each switch notably includes a transistor, for example of the IGBT type, associated with a diode.

In a switching arm of an inverter, the two switches are controlled by complementary PWM signals, meaning that when one switch is closed, the other switch is open, and vice versa. Additionally, to avoid both switches being closed at the same time, a dead time is inserted between the switching times of the two switches. During this dead time, both switches are open. This prevents short-circuits between the two power lines when both switches are closed, and avoids the current spikes caused by such short-circuits.

During the dead time, an output voltage applied on an electrical load may be determined by the sign of the current flowing through the switching arm. For instance, a positive current (flowing towards the load) generates a negative output voltage, and a negative current (flowing from the load towards the switches) generates a positive output voltage. This situation results in significant uncertainty about the actual output voltage applied during the dead time, which should be determined and considers in the PWM signals for improving the control of the electrical load.

To manage this situation, document EP2403119 A1 proposes to integrate the output voltage applied to the electrical load during a time window comprising a dead time and applying a compensation time in the PWM signals based on the integrated voltage.

The present disclosure improves the solution proposed by document EP2403119 A1.

BRIEF DESCRIPTION OF THE DRAWINGS

Figure 1 schematically illustrates an example of a PWM sequence for controlling two switches of a switching arm, and an integration time window of an output voltage according to document EP2403119 A1.
Figure 2 schematically illustrates an example of an inverter according to the present disclosure.
Figure 3 schematically illustrates an example of a PWM sequence for controlling two switches of a switching arm, and an effect of this sequence on an output voltage according to the present disclosure.
Figure 4 schematically illustrates an example of a system for compensating a dead time in a PWM control applied to a switching arm according to the present disclosure.
Figure 5a schematically illustrates an example of an electronic circuit of a system according to the present disclosure.
Figure 5b schematically illustrates another example of an electronic circuit of a system according to the present disclosure.
Figure 6 schematically illustrates an example of the different phases of an electronic circuit according to the present disclosure.
Figure 7a schematically illustrates yet another example of an electronic circuit of a system according to the present disclosure.
Figure 7b schematically illustrates yet another example of an electronic circuit of a system according to the present disclosure.
Figure 8 schematically illustrates an example of method for compensating a dead time in a PWM control applied to a switching arm according to the present disclosure.

DETAILED DESCRIPTION

The inventor has noticed that, in the solution presented by document EP2403119 A1, the time window during which the output voltage is integrated is larger than the effective duration of the dead time, which therefore adds an error in the integrated output voltage used to apply the compensation time in the PWM signals. The document especially indicates that the duration of the integration time window Wint is set to be slightly larger than the dead time duration for considering the time propagation of the switching order and the time for commuting the switches.

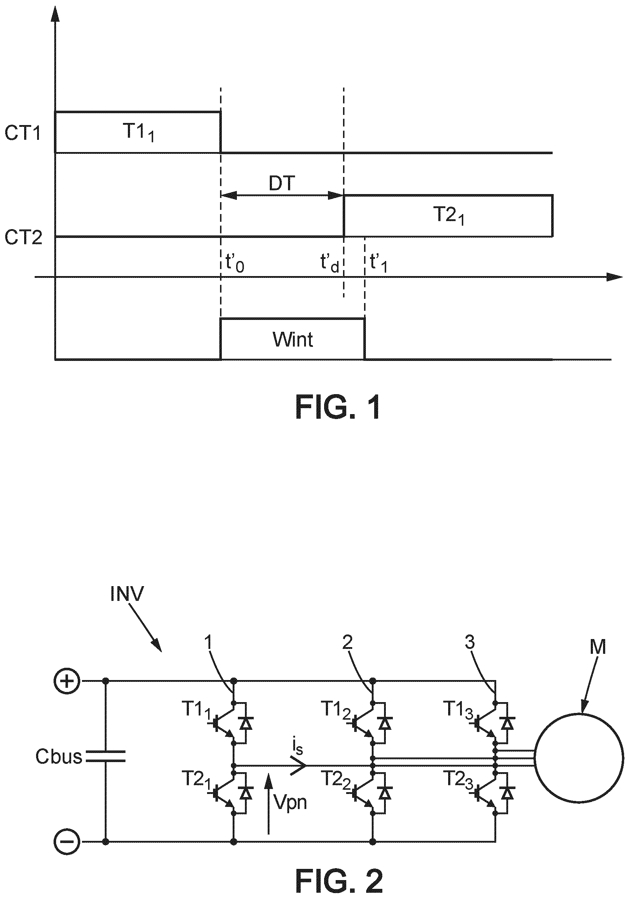

The overlap of the integration time window Wint in the conducting time of a switch of a switching arm following the dead time of document EP 2403119 A1 is represented in figure 1 of the present application, and corresponds to the duration between $t'_d$ and $1'_1$, wherein $t'_d$ is the effective end of the dead time, and $t'_1$ is the effective end of the integration time window Wint. In this figure, CT1 represents a PWM signal of a first switch $T1_1$ and CT2 represents a PWM signal of a second switch $T2_1$. As represented in the figure, the duration between $t'_d$ and $t'_1$, which is a part of the integration window Wint, corresponds to a conducting time of the second switch $T2_1$. It should therefore be noted that the voltage integrated during the time between $t'a$ and $t'_1$ does not correspond to an output voltage applied to the electrical load during the dead time DT, although it is considered to correct the PWM signals.

To mitigate or even suppress this overlap of the integrating time window Wint on the next conducting cycle, the inventor cleverly proposes to analogically synchronize the integration of the output voltage with the dead time. Hence, the obtained integrated output voltage during the dead time does not comprise any component belonging to a time in which a switch was conducting.

With reference to figure 2, it is now presented an example of an inverter INV, which can be used in a variable speed drive, and in which the solution proposed by the disclosure can be applied.

By inverter, we mean all conventional two-level or multi-level inverters that include a Direct Current, DC, bus, as well as so-called flying capacitor inverters and matrix converter-type inverters. In the following description, we focus on a conventional two-level inverter, but it should be understood that the solution of the disclosure may be applied to all of the aforementioned inverters, and more generally to each device comprising a switching arm.

An inverter INV comprises two power lines, a positive power line and a negative power line, between which a bus capacitor Cbus and several switching arms 1, 2, 3 are connected. Typically, each switching arm 1, 2, 3 includes at least two switches ($T1_1$, $T2_1$, $T1_2$, $T2_2$, $T1_3$, $T2_3$) connected between the two power lines. In each arm 1, 2, 3, a connection midpoint located between the two switches is connected to the electrical load M.

The solution of the present disclosure can be applied to each switching arm of the inverter independently. In the following description, we will focus on a single switching arm 1, which may for example comprise the switches $T1_1$ and $T2_1$.

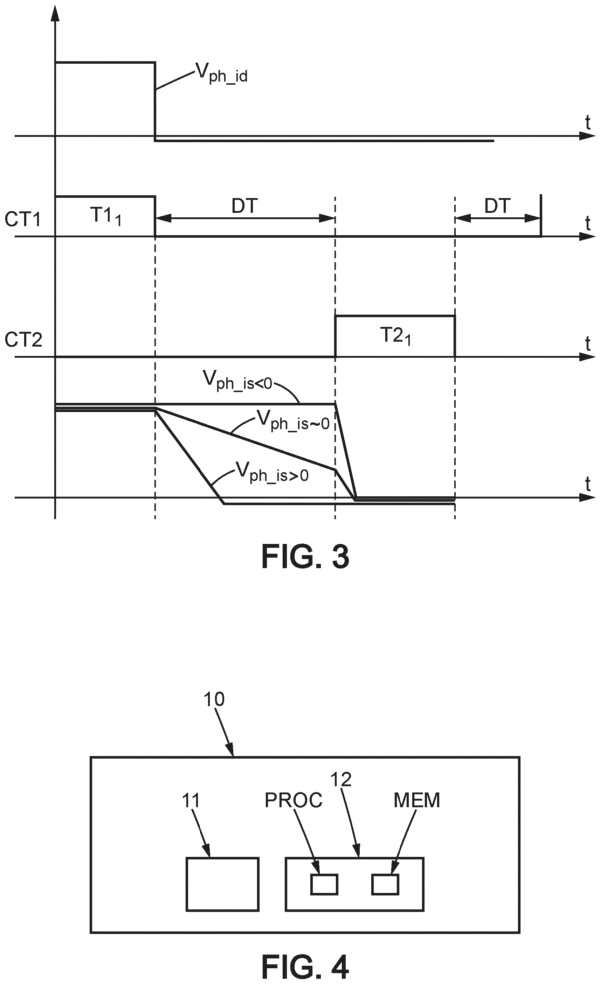

Referring to Figure 3, a PWM control sequence for controlling the switches $T1_1$ and $T2_1$ of the switching arm 1 includes, in a chronological order:

**1)** maintaining switch $T1_1$ closed for a certain duration (curve CT1),
**2)** a command to open the switch $T1_1$ (curve CT1),
**3)** a dead time DT during which both switches $T1_1$ and $T2_1$ are open,
**4)** a command to close switch $T2_1$ (curve CT2),
**5)** maintaining switch $T2_1$ closed for a certain duration (curve CT2),
**6)** a command to open switch $T2_1$ (curve CT2),
**7)** a new dead time DT,
**8)** a command to close switch $T1_1$ (curve CT1).

The switching duration of the switches are determined based on an output voltage Vph that is desired to be applied to the electrical load M. Outside the dead time DT, the output voltage Vph is controlled since one of the switches is always closed. However, during the dead time DT, which is necessary to prevent short-circuiting the DC bus, the evolution of the output voltage Vph applied to the electrical load M depends on the sign and value of the current (noted $i_s$ figure 2) flowing through the electrical load M. Figure 3 illustrates this aspect. In this figure, it can be seen that the actual output voltage Vph obtained from the switching arm presents different profiles depending on whether the current is positive (Vph_is > 0), negative (Vph_is < 0), or near zero (Vph_is ~ 0). This figure also shows the ideal voltage Vph_id that is desired.

With reference to figure 4, it is now presented an example of system 10 for compensating a dead time DT in a PWM control applied to a switching arm in order to apply an output voltage Vph to a first electrical load M.

The example of system 10 comprises an electronic circuit 11 and a data processing device 12.

The data processing device 12 may for example comprise a processor PROC and a memory MEM. The processor PROC may implement a PWM control based on a control law of the first electrical load M. The control law performed by the processor PROC makes it possible to determine the output voltage Vph to be applied to the output phases intended to be connected to the electric load M to be controlled. The processor PROC may be configured to operate at least a part of any examples of the method 100 hereby described.

The memory MEM may correspond to a non-transitory machine-readable or computer readable storage medium. The memory MEM may be encoded with instructions executable by a controller such as the controller PROC. The memory MEM may comprise instructions to operate the controller PROC to perform at least a part of the examples of the method 100 hereby described. The memory MEM according to this disclosure may be any electronic, magnetic, optical or other physical storage device that stores executable instructions. The memory MEM may be, for example, Random Access Memory (RAM), an Electrically Erasable Programmable Read Only Memory (EEPROM), a storage drive, an optical disk, and the like. The controller PROC has therefore access to the information stored in the memory MEM.

The electronic circuit 11 is configured to integrate the output voltage Vph during a time window Wint analogically synchronized with the dead time DT in order to determine a compensation duration of a pulse of the PWM control.

By time window Wint analogically synchronized with the dead time DT, the present disclosure means that the time window Wint is synchronized with the electric signals of the switching orders of the switches $T1_1$, $T2_1$, such that the time window Wint starts with an opening order of one the switches $T1_1$, $T2_1$ and ends with a closing order of the other switch.

By measuring the integral of the output voltage Vph over the duration of the time window Wint analogically synchronized with the dead time DT, the system 10 allows determining with precision the output voltage Vph applied to the first electrical load M during a duration (the dead time DT) where it is the most uncertain. The output voltage Vph applied to the first electrical load M is determinate with more accuracy than using the solution proposed by document EP2403119 A1 in which the determined applied output voltage comprises a component external to the dead time DT, considering that the integration time window Wint is always defined to be slightly larger than the dead time DT (see figure 1).

The data processing device 12 is configured to determine a width of a pulse of the PWM control based on the compensation duration; and to apply the pulse. The pulse may preferably be the next pulse following the dead time DT during which the output voltage has been integrated, i.e. the pulse following the integration time window Wint.

Since the output voltage Vph is integrated during a time window Wint analogically synchronized with the dead time DT, the obtained integrated output voltage does not comprise any component belonging to time in which a switch was conducting. Hence, the compensation duration determined based on said integrated voltage is more precise than the one determined in document EP2403119 A1, such that the control of the electrical load may be improved.

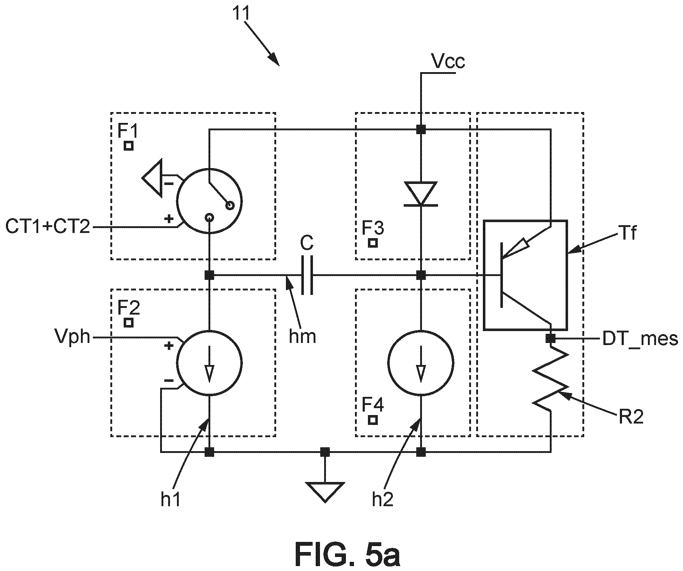

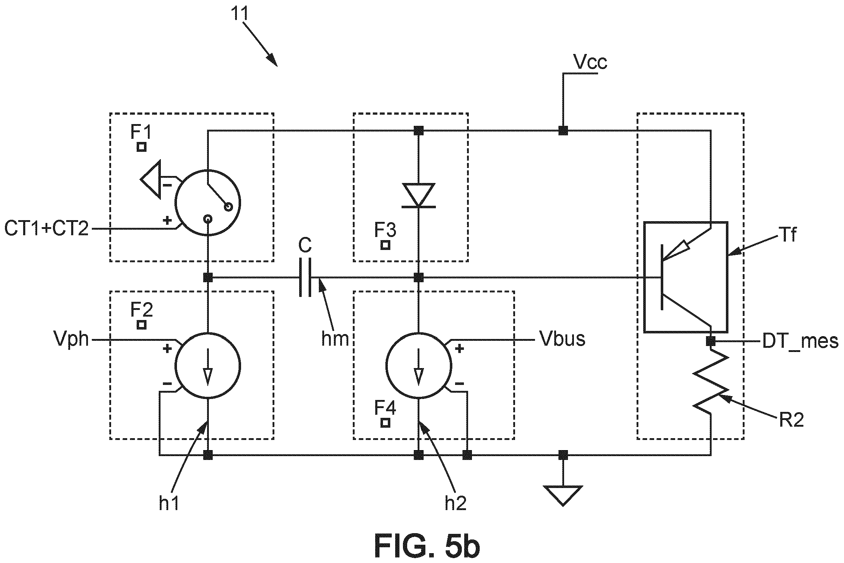

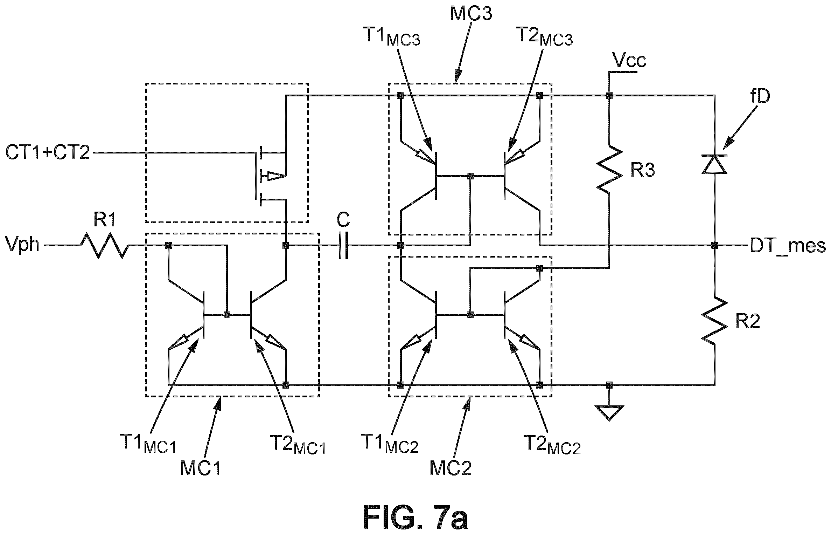

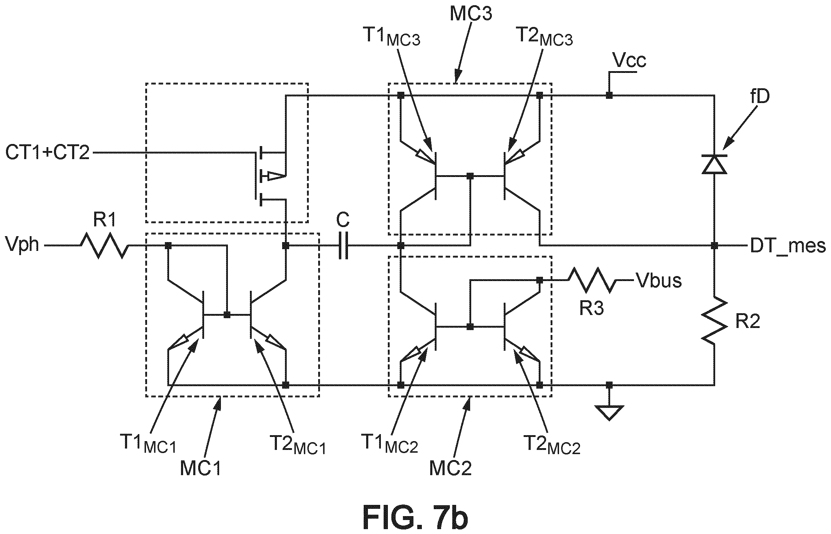

Examples of electronic circuit 11 configured to integrate the output voltage Vph during a time window Wint analogically synchronized with the dead time DT will be presented in reference to figures 5a, 5b, 7a and 7b. These figures represent possible examples of electronic circuit 11 allowing integrating the output voltage Vph during a time window Wint analogically synchronized with the dead time DT, but other examples can be implemented.

In some examples, the electronic circuit 11 may comprise a H-topology circuit and an output circuit.

The output circuit may be understood as an electronic circuit delivering a voltage signal with a width proportional to the integrated output voltage, as explained below.

The H-topology circuit comprising a first arm h1, a second arm h2, and a middle arm hm connected between the first h1 and the second h2 arms. The middle arm hm is connected to a respective connection midpoint of the first arm h1 and of the second arm h2. The arms h1, h2 and hm therefore form the H-topology circuit.

The middle arm hm comprises a capacitor C. The capacitor C will be used to integrate the output voltage Vph during the time window Wint analogically synchronized with the dead time DT.

In some examples illustrated in figures 5a and 5b, the first arm h1 comprises a switching circuit F1, a first current source F2, and a first connection midpoint arranged between the switching circuit F1 and the current source F2. The first connection midpoint connects the first arm h1 to the middle arm hm. The first connection midpoint especially connects the first arm h1 to a first terminal of the capacitor C.

A first terminal of the switching circuit F1 may be connected to a voltage line Vcc. A second terminal of the switching circuit F1 may be connected to the first connection midpoint. A first terminal of the first current source F2 may be connected to the first connection midpoint of the first arm h1. A second terminal of the first current source F2 may be connected to a ground of the voltage line Vcc, as illustrated in the figures 5a and 5b. The first current source F2 generates a current dependent from the output voltage Vph, as illustrated in the figures 5a et 5b. In other words, the first current source F2 corresponds to a voltage controlled current source.

In some examples illustrated in figures 5a and 5b, the switching circuit F1 is controlled based on electric signals (noted CT1 and CT2) respectively controlling the first switch $T1_1$, and the second switch $T2_1$. In other words, the switching circuit F1 is controlled based on PWM signals. The switching circuit F 1 is especially controlled to be off during the dead time DT and to be on when one of the switches ($T1_1$, $T1_2$) is on. The switching circuit F 1 may only be off during the dead time DT and may only be on when one of the switches ($T1_1$, $T1_2$) is on.

In some examples illustrated in figures 5a and 5b, the second arm h2 comprises a diode circuit F3, a second current source F4, and a second connection midpoint arranged between the diode circuit F3 and the second current source F4.

As explained below, the second current source F4 will be used to discharge the capacitor C after that the capacitor C integrates the output voltage Vph during a dead time DT. It is then based on a time of discharge of the capacitor C that a compensation duration will be determined. Hence, the second current source F4 may be:

- constant, i.e. defined by the characteristics of the components used, as illustrated in figure 5a.

In this case, during the capacitor discharge, actual volt-seconds are recovered, which must then be normalized by the DC bus voltage to correct the pulse width for compensation,

- dependent, i.e., proportional to the DC bus voltage at the inverter input, as illustrated in figure 5b where the DC bus voltage is referenced as $V_{bus}$.

In this case, the measured integral is already normalized by the DC bus voltage $V_{bus}$ and directly corresponds to a time that can be used for compensation.

The second connection midpoint connects the second arm h2 to the middle arm hm. The second connection midpoint especially connects the second arm h2 to a second terminal of the capacitor C. The diode circuit F3 may be arranged in the second arm to prevent a current to flow from the midpoint of the second arm h2 to the voltage line Vcc, as illustrated in figures 5a and 5b.

A first terminal of the diode circuit F3 (the anode) may be connected to the voltage line Vcc. A second terminal (the cathode) of the diode circuit F3 may be connected to the second connection midpoint of the second arm h2. A first terminal of the second current source F4 may be connected to the second connection midpoint. A second terminal of the second current source F4 may be connected to the ground of the voltage line Vcc.

In some examples illustrated in figures 5a and 5b, the output circuit comprises a transistor function Tf, i.e. an electronic component which can be controlled like a transistor. Here, the transistor function TF may be controlled such that the transistor function Tf is on when the diode circuit F3 is on and is off when the diode circuit F3 is off. That is, the emitter-base of the transistor function Tf may be connected in parallel to the diode circuit F3.

*Functioning principles of the electronic architecture of figures 5a and 5b:*

As previously explained, the electronic architecture of figure 5 allows integrating the output voltage Vph during the dead time DT by charging the capacitor C. This architecture also allows triggering a pulse of a width proportional to the integrated output voltage, which can therefore be processed, for example by the data processing device 12 to determine a compensation duration for a pulse of the PWM control.

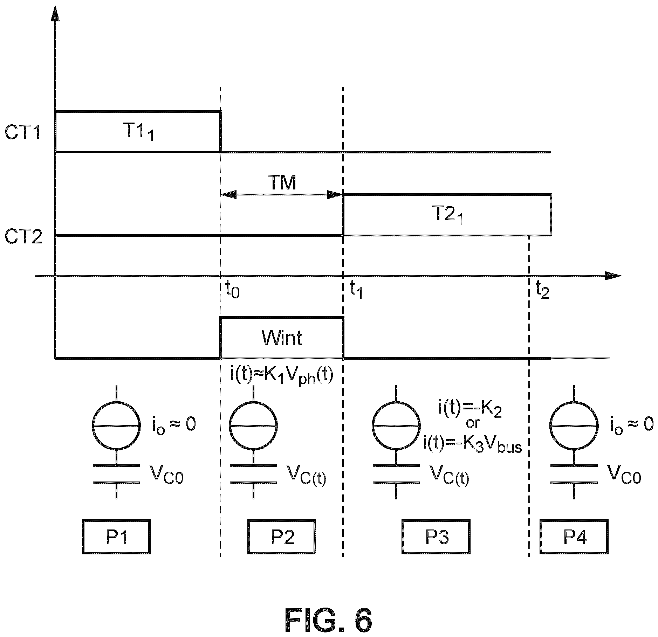

The functioning principles of the electronic architecture will be explained based on figure 6 representing the different phases of the electronic circuit 11.

In phase 1 (P1), until instant $t_0$ (which corresponds to an opening order of the switch $T1_1$), the switch $T1_1$ is on (CT1 = 1), and the voltage across the capacitor C is constant and equals to a resting voltage labeled $V_{C0}$. That is, no current flows through the capacitor C.

At instant $t_0$, the switch $T1_1$ is open (CT1 = 0) starting the integration time window Wint. The electronic circuit is in phase 2 (P2). Indeed, since both switches of the switching arm are open (CT1 + CT2 = 0), the dead time DT starts. Moreover, for the same reason (i.e. CT1 + CT2 = 0), the switching circuit F1 is off. Since the switching circuit F1 is off, a current flowing through the diode circuit F3 and attracted by the first current source F2 is charging the second terminal of the capacitor C. It is reminded that the current i(t) drawn by the first current source F2 and charging the second terminal of the capacitor C is proportional to the output voltage $V_{ph}$. The current charging the capacitor C (especially its second terminal) therefore corresponds to i(t) ≈ $K_1 V_{ph}(t)$, where $V_{ph}(t)$ corresponds to the output voltage, and $K_1$ is a constant coefficient. It should also be noted that since the diode circuit F3 is on, the transistor function Tf is on too (the emitter-base terminals of the transistor function Tf are connected in parallel of the terminals of the diode circuit F3), such that a voltage corresponding to the voltage line Vcc can be measured between the collector of the transistor function Tf and a ground of the voltage line Vcc, which may be the ground of the electronic circuit 11.

At $t_1$, the dead time DT ends with the closing of the switch $T2_1$ (CT2 = 1). The voltage $V_C(t_1)$ across the capacitor is given by the following relation:

$$V_C(t_1) = V_{C0} + \frac{K_1}{C}\int_{t_0}^{t_1} V_{ph}(t)dt \qquad (1)$$

We are entering in phase P3, from $t_1$ to $t_2$. The switching circuit F1 is closed (CT1 + CT2 = 1 since CT2 = 1), such that the first terminal of the capacitor C is connected to the voltage line Vcc. However, the second terminal of the capacitor C, since it has been charged during phase P2, presents a voltage greater than the voltage line Vcc. Hence, at this point, the capacitor C is discharged using the second current source F4 until the capacitor reaches its resting voltage $V_{C0}$ at $t_2$. The evolution of the voltage across the capacitor C during the discharge depends on whether the second current source F4 is constant (examples illustrated in figure 5a) or dependent (examples illustrated in figure 5b), as detailed below.

When the second current source F4 is constant following the relation i(t) = $-K_2$, wherein $K_2$ is a constant, the evolution of the voltage Vc(t) across the capacitor C current is given by the following relation:

$$V_C(t) = V_C(t_1) - \frac{K_2}{C}(t - t_1)$$

Hence, since $V_C(t_2) = V_{C0}$ at $t_2$, we can obtain from (1) the following relation:

$$t_2 - t_1 = \frac{K_1}{K_2} \int_{t_0}^{t_1} V_{ph}(t)dt$$

When the second current source F4 is dependent on the DC bus voltage following the relation $i(t) = -K_3 V_{bus}$, wherein $K_3$ is a constant while $V_{bus}$ corresponds to the DC-bus voltage, the evolution of the voltage Vc(t) across the capacitor C current is given by the following relation:

$$V_C(t) = V_C(t1) - \frac{K_3}{C} \int_{t_1}^{t} V_{bus}(u)du$$

If we consider the DC-bus voltage $V_{bus}$ constant during $t_1$ and $t_2$, we can obtain the following equation of voltage Vc(t) across the capacitor C:

$$V_C(t) \approx V_C(t_1) - \frac{K_3 V_{bus}}{C}(t - t_1)$$

and then we can therefore obtain:

$$t_2 - t_1 = \frac{K_1}{K_2} \int_{t_0}^{t_1} V_{ph}(t)dt$$

The instant $t_2$ can then be used to calculate a compensation duration to be applied in the PWM control to determine a width of a pulse of a PWM signal of a switch, as explained in EP2403119 A1.

It should be noted that during phase P3, the current cannot pass by the diode circuit F3 (the diode circuit F3 is off) since the potential of the second terminal of the diode circuit F3 (the cathode) is equal to the potential of the second terminal of the capacitor C, which is greater than the potential of the first terminal of the diode circuit F3 (the anode) corresponding to the potential of the voltage line Vcc. We understand that during the time period, the transistor function Tf is off since the emitter-base terminals of the transistor function Tf are connected in parallel of the diode circuit F3.

Then, when the second terminal of capacitor C is sufficiently discharged by the second current source F4 (at $t_2$), the diode circuit F3 becomes again on (as well as the transistor function Tf) such that no more current is charging or discharging the second terminal of the capacitor C (phase P4) until reaching the next dead time DT.

We understand that since the diode circuit F3 is off during phase P3, from $t_1$ to $t_2$, a voltage measured between the collector of the transistor function Tf and the ground of the voltage line Vcc of the electronic circuit 11 is equal to 0 during this phase. Hence, by monitoring this voltage, and especially by monitoring the voltage transition from 0 to Vcc, it is possible to analogically determine the end of the discharge of the capacitor C, and therefore determine the instant $t_2$ which can then be used to compute the compensation duration. The instant $t_1$ may be obtained based on the PWM signals. In some examples, the compensation duration may be determined based on a duration during when the transistor function Tf is off, which therefore corresponds to the discharging time of the capacitor C.

In some examples, the output circuit may also comprise a second resistor R2 (a first resistor R1 will be introduced below). A first terminal of the second resistor R2 may be connected to a collector of the transistor function Tf. A second terminal of the second resistor R2 may be connected to the ground of the voltage line Vcc (which may correspond to the ground of the electronic circuit 11). The compensation duration may be determined based on a voltage across the second resistor R2.

In some examples, the switching circuit F1 may comprise or may correspond to a metal-oxide-semiconductor field-effect transistor, MOSFET, and especially to a P-channel MOSFET.

A source of the MOSFET may be connected to the voltage line Vcc. The source of the MOSFET may thereby be connected to the diode circuit F3 (especially to its anode), and to the transistor function Tf (especially to its emitter) through the voltage line Vcc.

A gate of the MOSFET may be controlled based on electric signals (CT1, CT2) triggering the first switch $T1_1$ and the second switch $T2_1$.

A drain of the MOSFET may be connected to a first terminal of the capacitor C, and to the first source of current F2.

In some examples, the first current source F2 may correspond to a first current mirror MC1.

6

A collector of a first transistor $T1_{MC1}$ of the first current mirror MC1 may be connected to a first terminal of a first resistor R1. The second terminal of the first resistor R1 may be connected to the output voltage Vph.

A collector of a second transistor $T2_{MC1}$ of the first current mirror MC1 may be connected to a first terminal of the capacitor C and to the switching circuit F1, especially to a drain of the MOSFET when the switching circuit F1 comprises a MOSFET.

An emitter of a first transistor $T1_{MC1}$ and an emitter of a second transistor $T2_{MC1}$ of the first current mirror MC1 may be connected to the ground of the voltage line Vcc.

In some examples, the second current source F4 may correspond to a second current mirror MC2.

A collector of a first transistor $T1_{MC2}$ of the second current mirror MC2 may be connected to the second terminal of the capacitor C and to the diode circuit F3 (especially to its cathode).

A collector of a second transistor $T2_{MC1}$ of the second current mirror MC2 may be connected to a first terminal of a third resistor R3. In some examples wherein the second current source F4 is a constant current source, a second terminal of the third resistor R3 may be connected to the voltage line Vcc (as illustrated in figure 7a). In some examples wherein the second current source F4 is a current source dependent on the DC bus voltage $V_{bus}$, a second terminal of the third resistor R3 may be connected to the DC bus voltage $V_{bus}$ (as illustrated in figure 7b).

An emitter of a first transistor $T1_{MC2}$ and an emitter of a second transistor $T2_{MC2}$ of the second current mirror MC2 may be connected to the ground of the voltage line Vcc.

In some examples, the diode circuit F3 and the transistor function Tf are formed by a third current mirror MC3.

An emitter of a first transistor $T1_{MC3}$ and an emitter of a second transistor $T2_{MC3}$ of the third current mirror MC3 may be connected to the switching circuit F1 through the voltage line Vcc.

A collector of the first transistor $T1_{MC3}$ of the third current mirror MC3 may be connected to the second terminal of the capacitor C and to the second current source F2.

A collector of the second transistor $T2_{MC3}$ of the third current mirror MC3 may be connected to the first terminal of the second resistor R2. A second terminal of the second resistor R2 may be connected to the ground of the voltage line Vcc.

In some examples, a freewheeling diode fD may be connected in parallel to the second transistor $T2_{MC3}$ of the third current mirror MC3 for protecting the latter transistor against voltage spikes. A cathode of the freewheeling diode fD may therefore be connected to the switching circuit F1 (especially to a source of the MOSFET when the switching circuit F1 comprises a MOSFET), and to the emitters of the first $T1_{MC3}$ and second $T2_{MC3}$ transistors of the third current mirror MC3 through the voltage line Vcc. An anode of the freewheeling diode fD may be connected to the first terminal of the second resistor R2 and to the collector of the second transistor $T2_{MC3}$ of the third current mirror MC3. These examples are for example illustrated in figures 7a and 7b.

In some examples of electronic circuit 11 illustrated in figures 7a and 7b, the output circuit comprises the second resistor R2. The first current source F2 corresponds to the first current mirror MC1. The second current source F4 corresponds to the second current mirror MC2. The diode circuit F3 and the transistor function Tf are formed by the third current mirror MC3. The switching circuit F1 corresponds to a MOSFET.

In some examples of electronic circuit 11 illustrated in figures 7a and 7b, the collector of the first transistor $T1_{MC1}$ of the first current mirror MC1 is connected to the first terminal of the first resistor R1. The second terminal of the first resistor R1 is connected to the output voltage Vph. The collector of the second transistor $T2_{MC1}$ of the first current mirror MC1 is connected to the first terminal of the capacitor C and to the drain of the MOSFET. The emitter of the first transistor $T1_{MC1}$ and the emitter of the second transistor $T2_{MC1}$ of the first current mirror MC1 are connected to the ground of the voltage line Vcc, which again may correspond to the ground of the electronic circuit 11.

In some examples of electronic circuit 11 illustrated in figures 7a and 7b, the collector of the first transistor $T1_{MC2}$ of the second current mirror MC2 is connected to the second terminal of the capacitor C and to the collector of the first transistor $T1_{MC3}$ of the third current mirror MC3. The collector of a second transistor $T2_{MC2}$ of the second current mirror MC2 is connected to the first terminal of the third resistor R3. In some examples wherein the second current source F4 is a constant current source, the second terminal of the third resistor R3 is connected to the voltage line Vcc (figure 7a). In some examples wherein the second source of current F4 is a current source dependent on the DC bus voltage $V_{bus}$, the second terminal of the third resistor R3 is connected to the DC bus voltage $V_{bus}$ (as illustrated in figure 7b).

The emitters of the first $T1_{MC2}$ and second $T2_{MC2}$ transistors of the second current mirror MC2 and the second terminal of the second resistor R2 are connected to the ground of the voltage line Vcc. Hence, the emitters of the transistors of the first MC1 and second MC2 mirrors of current and the second terminal of the resistor R2 are connected to the ground of the voltage line Vcc.

In some examples of electronic circuit 11 illustrated in figures 7a and 7b, the emitter of the first transistor $T1_{MC3}$ and the emitter of the second transistor $T2_{MC3}$ of the third current mirror MC3 are connected to the source of the MOSFET through the voltage line Vcc. The emitter of the first transistor $T1_{MC3}$ and the emitter of the second transistor $T2_{MC3}$ of the third current mirror MC3 may also be connected to the cathode of the freewheeling diode fD.

The collector of the first transistor $T1_{MC3}$ of the third current mirror MC3 is connected to the second terminal of the capacitor C and to the collector of the first transistor $T1_{MC2}$ of the second current mirror MC2. The collector of the second transistor $T2_{MC3}$ of the third current mirror MC3 is connected to the first terminal of a second resistor R2. The collector of the second transistor $T2_{MC3}$ of the third current mirror MC3 may also be connected to the anode of the freewheeling diode fD..

In some examples of electronic circuit 11 illustrated in figure figures 7a and 7b, the source of the MOSFET is connected to the emitter of the first transistor $T1_{MC3}$ and to the emitter of a second transistor $T2_{MC3}$ of the third current mirror MC3 through the voltage line Vcc. The source of the MOSFET may also be connected to the cathode of the freewheeling diode fD. The gate of the MOSFET is controlled based on electric signals triggering the first switch $T1_1$ and the second switch $T2_1$. The drain of the MOSFET is connected to the first terminal of the capacitor C, and to the collector of the second transistor $T2_{MC1}$ of the first current mirror MC1.

In some examples of electronic circuit 11 illustrated in figures 7a and 7b, the compensation duration is determined based on a voltage across the second resistor R2.

In the examples of electronic circuit 11 illustrated in figure figures 7a and 7b, the electronic circuit 11 may be implemented as an Application-Specific Integrated Circuit, ASIC. Implementing the electronic circuit 11 as an ASIC provides significant advantages, including a compact design and cost efficiency for large-scale production, making it well suited for integration into the existing inverters.

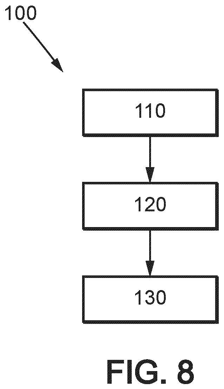

Examples of method 100 for compensating dead times DT in a PWM control applied to a switching arm will be presented in reference to figure 8.

As illustrated by block 110, the method 100 comprises an integration of the output voltage Vph during a time window Wint analogically synchronized with the dead time DT in order to determine a compensation duration of a pulse of the PWM control. The compensation duration of a pulse of the PWM control may be determined based on the discharging time of the capacitor C as previously explained, for example based on the instants $t_1$ and $t_2$.

As illustrated by block 120, the method 100 comprises determining a width of a pulse of the PWM control based on the compensation duration. The pulse may preferably be the next pulse following the dead time DT during which the output voltage has been integrated, i.e. the pulse following the integration time window Wint, as explained above.

As illustrated by block 130, the method 100 comprises applying the pulse determined in block 120.

In some examples, the integration of the output voltage Vph during a time window Wint analogically synchronized with the dead time DT of block 110 is implemented by any one of the examples of electronic circuit 11 presented in the present disclosure.

The present disclosure also presents a computer-readable storage medium comprising instructions which, when executed by at least one controller, cause the controller to carry out any one of the methods presented hereby.

The present disclosure also describes a computer program product comprising instructions which, when the program is executed by a computer, cause the computer to carry out any one of the methods hereby described.

The terms used herein are for the purpose of describing specific examples only and are not intended to limit the present disclosure. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, blocks, constitutional elements, components and/or combinations thereof, but do not preclude the presence or addition of one or more other features, integers, steps, operations, blocks, constitutional elements, components, and/or combinations thereof.

The various examples described above can be combined to provide further examples. These and other changes can be made to the examples in light of the above-detailed description. In general, in the following claims, the terms used should not be construed to limit the claims to the specific examples disclosed in the specification, but should be construed to include all possible examples along with the full scope of equivalents to which such claims are entitled.

## Claims

1. System (10) for compensating a dead time (DT) in a Pulse Width Modulation, PWM, control applied to a switching arm (1) in order to apply an output voltage (Vph) to a first electrical load (M);

   the switching arm comprising a first switch ($T1_1$), a second switch ($T2_1$) and a connection midpoint arranged between the first switch and the second switch and connected to the electrical load (M);
   the system (10) comprising:

   an electronic circuit (11) configured to integrate the output voltage (Vph) during a time window (Wint) analogically synchronized with the dead time (DT) in order to determine a compensation duration of a pulse of the PWM control;
   a data processing device (12) configured to:
   determine a width of a pulse of the PWM control based on the compensation duration; and apply the pulse.

2. System according to the preceding claim, wherein the electronic circuit (11) comprises a H-topology circuit and an output circuit;

the H-topology circuit comprising a first arm (h1), a second arm (h2), and a middle arm (hm) connected between the first (h1) and the second (h2) arms to form the H-topology;
the middle arm (hm) comprising a capacitor (C);
the first arm comprising a switching circuit (F1), a first current source (F2), and a connection midpoint arranged between the switching circuit (F1) and the current source (F2) and connected to the middle arm (hm);
the second arm comprising a diode circuit (F3), a second current source (F4), and a connection midpoint arranged between the diode circuit (F3) and the current source (F4) and connected to the middle arm (hm);
the output circuit comprises a transistor function (Tf) arranged such that the transistor function (Tf) is on when the diode circuit (F3) is on and is off when the diode circuit (F3) is off;
wherein the switching circuit (F1) is controlled based on electric signals controlling the first switch ($T1_1$), and the second switch ($T2_1$) such that the switching circuit (F1) is off during the dead time (DT) and is on when one of the switches ($T1_1$, $T2_1$) is on;
wherein the first current source (F2) is arranged to charge the capacitor (C) by a current proportional to the output voltage (Vph) when the switching circuit (F1) is off and when the diode circuit (F3) is on; and
wherein the second current source (F4) is arranged to discharge the capacitor (C) when the switching circuit (F1) is on and when the diode circuit (F3) is off.

3. System according to claim 2, wherein the compensation duration is determined based on the time during when the transistor function (Tf) is off.

4. System according to any one of the claims 2 or 3, wherein the switching circuit (F1) comprises a P-channel metal-oxide-semiconductor field-effect transistor, MOSFET;

wherein a source of the MOSFET is connected to the diode circuit (F3) and to the transistor function (Tf) through a voltage line (Vcc);
a gate of the MOSFET is controlled based on electric signals controlling the first switch ($T1_1$) and the second switch ($T2_1$);
and a drain of the MOSFET is connected to a first terminal of the capacitor (C), and to the first source of current (F2).

5. System according to any one of the claims 2 to 4, wherein the first current source (F2) corresponds to a first current mirror (MC1).

6. System according to claim 5, wherein a collector of a first transistor ($T1_{MC1}$) of the first current mirror (MC1) is connected to a first terminal of a first resistor (R1), the second terminal of the first resistor (R1) being connected to the output voltage (Vph);

wherein a collector of a second transistor ($T2_{MC1}$) of the first current mirror (MC1) is connected to a first terminal of the capacitor (C) and to the switching circuit (F1); and
wherein an emitter of a first transistor ($T1_{MC1}$) and an emitter of a second transistor ($T2_{MC1}$) of the first current mirror (MC1) are connected to a ground of a voltage line (Vcc).

7. System according to any one of the claims 2 to 6, wherein the second current source (F4) corresponds to a second current mirror (MC2).

8. System according to claim 7, wherein a collector of a first transistor ($T1_{MC2}$) of the second current mirror (MC2) is connected to a second terminal of the capacitor (C) and to the diode circuit (F3);

wherein a collector of a second transistor ($T2_{MC2}$) of the second current mirror (MC2) is connected to a first terminal of a third resistor (R3), the second terminal of the third resistor (R3) being connected either to a voltage line (Vcc) or to a DC bus voltage ($V_{bus}$); and
wherein an emitter of a first transistor ($T1_{MC2}$) and an emitter of a second transistor ($T2_{MC2}$) of the second current mirror (MC2) are connected to a ground of the voltage line (Vcc).

9. System according to any one of the claims 2 to 8, wherein the diode circuit (F3) and the transistor function (Tf) are formed by a third current mirror (MC3).

10. System according to claim 9, wherein an emitter of a first transistor ($T1_{MC3}$) and an emitter of a second transistor ($T2_{MC3}$) of the third current mirror (MC3) are connected to the switching circuit (F1) through a voltage line (Vcc);

wherein a collector of the first transistor ($T1_{MC3}$) of the third current mirror (MC3) is connected to a second terminal of the capacitor (C) and to the second current source (F2);
wherein a collector of the second transistor ($T2_{MC3}$) of the third current mirror (MC3) is connected to a first terminal of a second resistor (R2);
and wherein a second terminal of the second resistor (R2) is connected to a ground of the voltage line (Vcc).

11. System according to any of the claims 1 to 10, wherein the output circuit comprises a second resistor (R2);

wherein a first terminal of the second resistor (R2) is connected to a collector of the transistor function (Tf);
wherein a second terminal of the second resistor (R2) is connected to a ground of the voltage line (Vcc); and
wherein the compensation duration is determined based on a voltage across the second resistor (R2).

12. System according to any one of the claims 2 to 11, wherein the output circuit comprises a second resistor (R2), the first current source (F2) corresponds to a first current mirror (MC1), the second current source (F4) corresponds to a second current mirror (MC2), the diode circuit (F3) and the transistor function (Tf) are formed by a third current mirror (MC3), and the switching circuit (F1) corresponds to a P-channel metal-oxide-semiconductor field-effect transistor, MOSFET;

wherein a collector of a first transistor ($T1_{MC1}$) of the first current mirror (MC1) is connected to a first terminal of a first resistor (R1), a second terminal of the first resistor (R1) being connected to the output voltage (Vph); a collector of a second transistor ($T2_{MC1}$) of the first current mirror (MC1) is connected to a first terminal of the capacitor (C) and to a drain of the MOSFET; an emitter of a first transistor ($T1_{MC1}$) and an emitter of the second transistor ($T2_{MC1}$) of the first current mirror (MC1) are connected to a ground of a voltage line (Vcc);
wherein a collector of a first transistor ($T1_{MC2}$) of the second current mirror (MC2) is connected to a second terminal of the capacitor (C) and to a collector of a first transistor ($T1_{MC2}$) of the third current mirror (MC3); a collector of a second transistor ($T2_{MC2}$) of the second current mirror (MC2) is connected to a first terminal of a third resistor (R3), a second terminal of the third resistor (R3) being connected either to the voltage line (Vcc) or to a DC bus voltage ($V_{bus}$); an emitter of the first transistor ($T1_{MC2}$), an emitter of the second transistor ($T2_{MC2}$) of the second current mirror (MC2), and a second terminal of the second resistor (R2) are connected to the ground of the voltage line (Vcc);
wherein an emitter of a first transistor ($T1_{MC3}$) and an emitter of a second transistor ($T2_{MC3}$) of the third current mirror (MC3) are connected to a source of the MOSFET through the voltage line (Vcc); a collector of the second transistor ($T2_{MC3}$) of the third current mirror (MC3) is connected to a first terminal of the second resistor (R2);
wherein a gate of the MOSFET is controlled based on electric signals controlling the first switch ($T1_1$) and the second switch ($T2_1$); and
wherein the compensation duration is determined based on a voltage across the second resistor (R2).

13. A method (100) for compensating dead times (DT) in a Pulse Width Modulation, PWM, control applied to a switching arm (1) connected between two supply lines, the switching arm comprising a first switch ($T1_1$), a second switch ($T2_1$) and a connection midpoint located between the first switch ($T1_1$) and the second switch ($T2_1$), and connected to an electrical load (M),

the PWM control performs a switching of the first switch ($T1_1$) and a switching of the second switch ($T2_1$) and inserts a dead time (DT) between the switching of the first switch ($T1_1$) and the switching of the second switch ($T2_1$), in order to apply an output voltage (Vph) to the electrical load (M),
wherein the method comprises:

integrating (110) the output voltage (Vph) during a time window (Wint) analogically synchronized with the dead time (DT) in order to determine a compensation duration of a pulse of the PWM control;
determining (120) a width of a pulse of the PWM control based on the compensation duration; and
applying (130) the pulse.

14. A method according to the preceding claim, wherein integrating the output voltage (Vph) during a determined time window (Wint) synchronized with the dead time (DT) is implemented by the electronic circuit of the system according to any one of the claims 1 to 12.

15. A computer-readable storage medium comprising instructions which, when executed by at least one controller, cause the at least one controller to carry out at least part of the method of any one of the above method claims.

**FIG. 1**

**FIG. 2**

$V_{ph\_id}$

CT1 $T1_1$ DT DT t

CT2 $T2_1$ t

$V_{ph\_is<0}$
$V_{ph\_is\sim0}$
$V_{ph\_is>0}$

## FIG. 3

10

11 PROC 12 MEM

## FIG. 4

FIG. 5a

**FIG. 5b**

FIG. 6

FIG. 7a

FIG. 7b

100

110

120

130

FIG. 8

Europäisches
Patentamt
European
Patent Office
Office européen
des brevets

# EUROPEAN SEARCH REPORT

**Application Number**

EP 24 30 6743

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 403 119 A1 (SCHNEIDER TOSHIBA INVERTER [FR]) 4 January 2012 (2012-01-04) | 1,13,15 | INV. H02M1/38 |
| A | * figures 1,3 * | 2-12,14 | H03K17/00 H02M7/5387 |
| X | US 2014/376275 A1 (OHASHI HIDETOMO [JP]) 25 December 2014 (2014-12-25) | 1,13,15 | H03K17/14 |
| A | * figures 1-2 * | 2-12,14 | |
| X | CN 113 162 374 B (SHANGHAI INST SPACE POWER SOURCES) 9 December 2022 (2022-12-09) | 1,13,15 | |
| A | * figure 1 * | 2-12,14 | |

**TECHNICAL FIELDS SEARCHED (IPC)**

H02M
H03K

The present search report has been drawn up for all claims

| Place of search | Date of completion of the search | Examiner |
|---|---|---|
| The Hague | 3 March 2025 | Magnanimo, Antonio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 30 6743

This annex lists the patent family members relating to the patent documents cited in  the above-mentioned European search report.
The members are as contained in the European Patent Office EDP file on
The European Patent Office is in no way liable for these particulars which are merely given for the purpose of information.

03-03-2025

| Patent document cited in search report | | Publication date | Patent family member(s) | | Publication date |
|---|---|---|---|---|---|
| EP 2403119 | A1 | 04-01-2012 | CN | 102315822 A | 11-01-2012 |
| | | | CN | 202276287 U | 13-06-2012 |
| | | | EP | 2403119 A1 | 04-01-2012 |
| | | | FR | 2961977 A1 | 30-12-2011 |
| | | | JP | 2012016268 A | 19-01-2012 |
| US 2014376275 | A1 | 25-12-2014 | CN | 104205596 A | 10-12-2014 |
| | | | JP | 6069957 B2 | 01-02-2017 |
| | | | JP | 2014045595 A | 13-03-2014 |
| | | | US | 2014376275 A1 | 25-12-2014 |
| | | | WO | 2014034530 A1 | 06-03-2014 |
| CN 113162374 | B | 09-12-2022 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2403119 A1